# EUROPEAN PATENT SPECIFICATION

(11) **EP 2 911 184 B1**
(45) Date of publication and mention of the grant of the patent: **24.07.2019**
(21) Application number: 13848733.5
(22) Date of filing: 15.10.2013
(51) Int. Cl.: G03F 7/00, G03F 7/027, G03F 7/029, G03F 7/031, G03F 7/075, B29L 31/00, B29C 33/40, B29C 33/38, B29C 59/02, C08F 2/48

(54) **PHOTOCURABLE RESIN COMPOSITION FOR IMPRINTING, METHOD FOR PRODUCING MOLD FOR IMPRINTING, AND MOLD FOR IMPRINTING**
LICHTHÄRTBARE HARZZUSAMMENSETZUNG ZUM PRÄGEN, VERFAHREN ZUR HERSTELLUNG EINER FORM ZUM PRÄGEN UND GIESSFORM ZUM PRÄGEN
COMPOSITION DE RÉSINE PHOTODURCISSABLE POUR IMPRESSION, PROCÉDÉ POUR PRODUIRE UN MOULE POUR IMPRESSION, ET MOULE POUR IMPRESSION

(30) Priority: 22.10.2012 JP 2012232883
(43) Date of publication of application: 26.08.2015
(73) Proprietor: Soken Chemical & Engineering Co., Ltd., Toshima-ku Tokyo 171-8531 (JP)
(72) Inventor: YAMADA, Hiroko, Sayama-shi Saitama 350-1320 (JP); SUTO, Yasuo, Sayama-shi Saitama 350-1320 (JP)
(74) Representative: Dehns
(86) International application number: PCT/JP2013/077903
(87) International publication number: WO 2014/065149

(56) References cited:
- WO-A1-2009/069557
- WO-A1-2011/126101
- WO-A1-2011/155499
- WO-A1-2012/014961
- WO-A1-2013/176020
- JP-A- 2008 019 292
- JP-A- 2008 105 414
- JP-A- 2008 202 022
- JP-A- 2009 073 078
- JP-A- 2011 235 571
- JP-A- 2012 033 517
- JP-A- 2012 214 716

## Description

### Technical Field

The present invention relates to a photocurable resin composition for imprinting; a method for producing an imprinting mold using the photocurable resin composition; and an imprinting mold formed by using the photocurable resin composition.

### Background Art

In imprinting technology, a master mold having a surface on which a fine structure at nano- or micron-scale is formed is pressed on a liquid resin, whereby the fine structure of the mold is transferred onto the resin. A structure having the fine structure formed by transferring, according to the shape of the fine structure, is used as an imprinting mold, an AR film, a diffusion film or the like, in various fields including semiconductor materials, optical materials, recording media, micro machines, biology and environment.

Exemplary methods for imprinting are thermal imprinting, in which a mold having a surface with a predetermined shape is press-contacted with a thermoplastic resin that has been molten at a temperature exceeding its glass transition temperature, whereby the surface shape of the mold is thermally imprinted on the thermoplastic resin, which is followed by cooling and mold-detaching; and photo-imprinting, in which such a mold as described above is pressed on a photocurable resin, which is followed by ultraviolet ray application to cure the photocurable resin, and then mold-detaching.

While conventional molds have been those made of quartz, silicon or the like, molds recently used have been those made of resins in view of versatility and cost. However, the resin molds, which are well compatible with thermosetting resins and photocurable resins used as transfer targets, cannot be easily separated from the transfer targets. Upon releasing, pattern shapes that have been formed on the transfer targets are damaged in some cases.

To address this, it is known to use a coupling agent such as a silane-based one as a releasing agent on a surface of the resin mold in order to control surface energy of the mold so as to fall within an appropriate range thereby imparting releasability (see, for example, Patent Literature 1). However, since that releasing agent cannot easily contact closely a transfer mold and peels therefrom, it is necessary to reapply the agent every several-time of uses. Prevention of the peeling requires controlling a thickness of the releasing agent layer, which is however not easy.

It is also known to add a silicone compound or a silicone resin to a mold-forming resin in order to improve its releasability (see, for example, Patent Literatures 2 and 3). However, that composition contains an oligomer, or the silicone compound and the silicone resin are an oligomer and a polymer, thus having high viscosity, and therefore cannot be easily applied thinly on a substrate. Another problem is flexibility of a mold obtained from that composition.

In the photo-imprinting for producing a resin mold, there is a problem that a transfer target resin, while being cured, undergoes curing shrinkage and fails to precisely reflect the shape of an original mold. In the photo-imprinting including transferring a fine structure at nano- or micron-scale, dimensional difference even at nano- or micron-scale is a problem.

In use of the resin mold produced by photo-imprinting as a mold for photo-imprinting, it is important that the mold do not have decreased transmittance due to its yellowing as a result of repeated application of ultraviolet ray, and it is demanded that the mold have enough hardness not to break because of repeated imprinting operation.

The yellowing and curing shrinkage of the resin often vary depending on photoinitiators used.

Patent Literature 4, directed to a resin mold formed by using composition containing a fluorine-containing monomer and a photoinitiator by means of photo-imprinting, discloses combining two kinds of initiators as the photoinitiator in view of dispersibility of the fluorine-containing monomer and curability of a photopolymerizable mixture. Patent Literature 4 describes in its Example a combination of Irgacure 184 and Irgacure 369 as photoinitiators contained in the photocurable resin composition; however, both are alkylphenone-based photoinitiators.

It is also referred to JP-A-2008-105414, which describes a resin for imprinting that comprises a polymerizable unsaturated monomer, a photopolymerization initiator, and various surfactants. This prior art document teaches that for improved adhesion to a substrate, monomers containing silicon or phosphorous or fluorine-based surfactants should be used.

Finally, further reference is made to JP-A-2011-235571, JP-A-2009-073078, WO-A1-2011/155499, and WO-A1-2009/069557, all of which are concerned with photocurable resin compositions for imprinting and imprinting molds.

Thus, there is a need to further study photoinitiators used for the photocurable resin composition for imprinting from the viewpoints of curing shrinkage of resin and the hardness and yellowing of the resultant mold.

### Citation List

### Patent Literatures

[Patent Literature 1] JP-A-2001-269942
[Patent Literature 2] JP-A-2006-523728
[Patent Literature 3] JP-A-2010-161186
[Patent Literature 4] JP-A-2011-207221

### Summary of the Invention

### Technical Problem

It is an object of the present invention to provide a photocurable resin composition for producing an imprinting mold which has superior releasability from a transfer target resin and is flexible.

It is another object of the present invention to provide a photocurable resin composition which does not undergo curing shrinkage when subjected to photo-imprinting as a transfer target of photo-imprinting. It is still another object of the present invention to provide a photocurable resin composition capable of producing by photo-imprinting an imprinting mold which has high surface hardness and in which the occurrence of yellowing is suppressed even when irradiated with e.g., ultraviolet ray.

### Technical Solution

The present inventors have found that by incorporating a silicon-containing monomer into a photocurable resin composition, the composition provides an imprinting mold superior in releasability from a transfer target resin. Further, the present inventors focused on a combination of plural photoinitiators of the photocurable resin composition and studied in detail its influence on the yellowing, curing shrinkage and hardness of the imprinting mold obtained from the composition by photo-imprinting. As a result, they have found that by combining photoinitiators belonging to specific types at a specific ratio, the yellowing of the imprinting mold obtained by photo-imprinting is suppressed, and moreover the imprinting mold has superior hardness and the curing shrinkage of the imprinting mold can be considerably decreased. Based on these findings, the present invention was perfected.

The present invention is defined by the appended claims 1 to 14 and concerns, for example, [1] to [15] described below.
[1] A photocurable resin composition for imprinting comprising a (meth)acrylic monomer (A), a silicon-containing monomer (B) having a reactive group copolymerizable with the component (A), and a photoinitiator (C), wherein the photoinitiator (C) comprises a combination of an alkylphenone-based photoinitiator (C1) and an acylphosphine oxide-based photoinitiator (C2), and wherein the (meth)acrylic monomer (A) is at least one kind selected from the group consisting of nonylphenol EO-modified acrylate, phenol EO-modified acrylate and tripropylene glycol diacrylate.
[2] The photocurable resin composition for imprinting according to [1], which comprises, with respect to 100 parts by weight of the (meth) acrylic monomer (A), 0.1 to 60 parts by weight of the silicon-containing monomer (B), 0.01 to 20 parts by weight of the alkylphenone-based photoinitiator (C1) and 0.01 to 20 parts by weight of the acylphosphine oxide-based photoinitiator (C2).
[3] The photocurable resin composition for imprinting according to [1] or [2], wherein the alkylphenone-based photoinitiator (C1) is at least one kind selected from the group consisting of 2,2-dimethoxy-1,2-diphenylethane-1-one, 1-hydroxy-cyclohexyl-phenyl-ketone, 2-hydroxy-2-methyl-1-phenyl-propane-1-one, 1-[4-(2-hydroxyethoxy)-phenyl]-2-hydroxy-2-methyl-propane-1-o ne and 2-hydroxy-1-{[4-(2-hydroxy-2-methyl-propionyl)-benzyl]phenyl} -2-methyl-propane-1-one.
[4] The photocurable resin composition for imprinting according to any one of [1] to [3], wherein the acylphosphine oxide-based photoinitiator (C2) is at least one kind selected from the group consisting of 2,4,6-trimethylbenzoyl-diphenyl-phosphine oxide and bis(2,4,6-trimethylbenzoyl)-phenylphosphine oxide.
[5] The photocurable resin composition for imprinting according to any one of [1] to [4], wherein a blending weight ratio (C1: C2) of the alkylphenone-based photoinitiator (C1) to the acylphosphine oxide-based photoinitiator (C2) is in the range of 1:99 to 90:10.
[6] The photocurable resin composition for imprinting according to [5], wherein the alkylphenone-based photoinitiator (C1) is 1-hydroxy-cyclohexyl-phenyl-ketone and the acylphosphine oxide-based photoinitiator (C2) is bis(2,4,6-trimethylbenzoyl)-phenylphosphine oxide, and wherein a blending weight ratio (C1: C2) of the alkylphenone-based photoinitiator (C1) to the acylphosphine oxide-based photoinitiator (C2) is in the range of 10:90 to 70:30.
[7] The photocurable resin composition for imprinting according to any one of [1] to [6], wherein the (meth)acrylic monomer (A) is at least one kind selected from the group consisting of EO-modified trimethylolpropene triacrylate, EO-modified bisphenol A diacrylate, nonylphenol EO-modified acrylate, phenol EO-modified acrylate and tripropylene glycol diacrylate.
[8] The photocurable resin composition for imprinting according to any one of [1] to [7], wherein the photocurable resin composition for imprinting contains no oligomers and/or no polymers.
[9] A method for producing an imprinting mold having a surface on which a fine pattern is formed, comprising:
   (I) a step of applying, on a substrate, the photocurable resin composition for imprinting according to any one of [1] to [8],
   (II) a step of bringing a master mold having a surface on which a fine pattern is formed into contact with the photocurable resin composition for imprinting applied on the substrate,
   (III) a step of applying light to the photocurable resin composition for imprinting provided between the substrate and the master mold to cure the photocurable resin composition for imprinting, and
   (IV) a step of releasing the master mold from the photocurable resin composition for imprinting that has been cured.
[10] A method for producing an imprinting mold having a surface on which a fine pattern is formed, comprising:
   (I) a step of dropwise adding the photocurable resin composition for imprinting according to any one of [1] to [8] on a master mold having a surface on which a fine pattern is formed,
   (II) a step of covering a surface of the photocurable resin composition for imprinting with a substrate,
   (III) a step of applying light to the photocurable resin composition for imprinting provided between the substrate and the master mold to cure the photocurable resin composition for imprinting, and
   (IV) a step of releasing the master mold from the photocurable resin composition for imprinting that has been cured.
[11] An imprinting mold obtained by the production process according to [9] or [10].
[12] The imprinting mold according to [11], which has been subjected to releasing treatment.
[13] The imprinting mold according to [11] or [12], which has a fine pattern with a shrinkage factor of not more than 10% with respect to the fine pattern of the master mold.
[14] The imprinting mold according to any one of [11] to [13], wherein a value obtained by subtracting a YI value of the mold before irradiated with light at 18,000 mJ/cm² from a YI value of the mold after irradiated with light at 18,000 mJ/cm² is 0.0 to 3.0.
[15] The imprinting mold according to any one of [11] to [14], which has a surface hardness of 3B to 3H in terms of pencil hardness in accordance with JIS K5600 5-4.

### Effects of the Invention

The photocurable resin composition of the present invention can produce an imprinting mold with superior releasability from a transfer target.

According to the present invention, a photocurable resin composition is prevented from undergoing curing shrinkage when subjected to photo-imprinting as a transfer target of photo-imprinting, giving a structure faithful to a shape of an original mold at a nano-order scale. An imprinting mold obtained from the photocurable resin composition of the present invention by photo-imprinting has high surface hardness. In addition, yellowing of the resultant imprinting mold that is caused by the application of e.g., ultraviolet ray is suppressed. Description of Embodiments

Hereinafter, the present invention will be specifically described.

The present invention is a photocurable resin composition for imprinting comprising a (meth)acrylic monomer (A) and a photoinitiator (C), wherein the photoinitiator (C) comprises a combination of an alkylphenone-based photoinitiator (C1) and an acylphosphine oxide-based photoinitiator (C2), wherein a blending weight ratio (C1: C2) of the alkylphenone-based photoinitiator (C1) to the acylphosphine oxide-based photoinitiator (C2) is in the range of 1:99 to 90:10.

In the specification, "(meth)acryl" means methacryl and/or acryl, and "(meth)acrylate" means methacrylate and/or acrylate.

### <Photocurable Resin Composition for Imprinting>

### 1. (Meth)acrylic Monomer (A)

In the photocurable resin composition for imprinting of the present invention, a photopolymerizable (meth) acrylic monomer is used, wherein the (meth)acrylic monomer (A) is at least one kind selected from the group consisting of nonylphenol EO-modified acrylate, phenol EO-modified acrylate and tripropylene glycol diacrylate.

Examples of the photopolymerizable (meth)acrylic monomer include multifunctional (meth)acrylic acid esters, monofunctional (meth)acrylic acid esters and functional group-containing monomers.

Examples of the multifunctional (meth)acrylic acid esters used in the present invention include EO-modified trimethylolpropane tri(meth)acrylate, EO-modified bisphenol A di(meth)acrylate, tripropylene glycol di(meth)acrylate, 1,4-butanediol di(meth)acrylate, 1,6-hexanediol di(meth)acrylate, 1,9-nonanediol di(meth)acrylate, (poly)ethylene glycol di(meth)acrylate, (poly)propylene glycol di(meth)acrylate, neopentyl glycol di(meth)acrylate, pentaerythritol di(meth)acrylate, pentaerythritol tri(meth)acrylate, pentaerythritol tetra(meth)acrylate, trimethylolpropane di(meth)acrylate, trimethylolpropane tri(meth)acrylate, polyester (meth)acrylate and urethane (meth)acrylate.

Examples of the monofunctional (meth)acrylic acid esters include:
(meth) acrylates having a linear alkyl group, such as methyl (meth)acrylate, ethyl (meth)acrylate, n-propyl (meth)acrylate, n-butyl (meth)acrylate, n-pentyl (meth)acrylate, n-hexyl (meth)acrylate, n-octyl (meth)acrylate, n-nonyl (meth)acrylate, decyl (meth)acrylate, dodecyl (meth)acrylate and styryl (meth)acrylate;
(meth)acrylic acid alkyl esters having a branched alkyl group, such as iso-propyl (meth)acrylate, iso-butyl (meth)acrylate, tert-butyl (meth)acrylate, 2-ethylhexyl (meth)acrylate and isooctyl (meth)acrylate;
(meth) acrylic acid alkyl esters having a cyclic alkyl group, such as isobornyl (meth)acrylate and cyclohexyl (meth)acrylate; and
(meth)acrylic acid esters having an aromatic group, such as benzyl (meth)acrylate, phenoxyethyl (meth)acrylate, nonylphenol EO-modified acrylate and phenol EO-modified acrylate.

Examples of the functional group-containing monomers include hydroxyl group-containing monomers, acid group-containing monomers, amino group-containing monomers, amide group-containing monomers and cyano group-containing monomers.

Examples of the hydroxyl group-containing monomers are hydroxyl group-containing compounds such as hydroxyl group-containing (meth) acrylic monomers including (meth) acrylic acid-2-hydroxyethyl, (meth)acrylic acid-2-hydroxypropyl, a monoester formed by (meth)acrylic acid and polypropylene glycol or polyethylene glycol, and an adduct formed by a lactone and (meth)acrylic acid-2-hydroxyethyl .

Examples of the acid group-containing monomers include carboxyl group-containing (meth)acrylic monomers such as (meth)acrylic acid, acid anhydride group-containing (meth)acrylic monomers, phosphoric acid group-containing (meth)acrylic monomers and sulfuric acid group-containing (meth)acrylic monomers.

Examples of the amino group-containing monomers or amide group-containing monomers include amino group-containing (meth)acrylic monomers such as N,N-dimethylaminoethyl (meth) acrylate and amide group-containing (meth) acrylic monomers such as (meth)acrylamide, N-methyl(meth)acrylamide, N-ethyl(meth)acrylamide, N-propyl(meth)acrylamide and N-hexyl(meth)acrylamide.

Examples of the cyano group-containing monomers include cyano(meth)acrylates.

As the (meth) acrylic monomer (A), in addition to the (meth)acrylic monomers described above, other (meth)acrylic monomers copolymerizable with the above (meth)acrylic monomers can be mentioned as described below.

Examples of the other copolymerizable (meth)acrylic monomers include epoxy group-containing (meth)acrylates such as glycidyl (meth)acrylate, alkoxy(meth)acrylates and allyl(meth)acrylates.

In 100 parts by weight of the (meth)acrylic monomer (A), the multifunctional (meth) acrylic acid ester preferably accounts for 50 to 100 parts by weight, more preferably 70 to 100 parts by weight; the monofunctional (meth) acrylic acid ester preferably accounts for 0 to 30 parts by weight, more preferably 0 to 20 parts by weight; the functional group-containing monomer preferably accounts for 0 to 30 parts by weight, more preferably 0 to 10 parts by weight; and the other copolymerizable (meth)acrylic monomer preferably accounts for 0 to 30 parts by weight, more preferably 0 to 10 parts by weight.

Among the (meth)acrylic monomers (A), preferred are monomers of EO-modified trimethylolpropene triacrylate, EO-modified bisphenol A diacrylate, nonylphenol EO-modified acrylate, phenol EO-modified acrylate and tripropylene glycol diacrylate; according to the invention the monomer (A) is at least one kind selected from the group consisting of monomers of nonylphenol EO-modified acrylate, phenol EO-modified acrylate and tripropylene glycol diacrylate. By using these monomers, when a substrate to which the photocurable resin composition for imprinting of the present invention is applied is made of polyethylene terephthalate, an imprinting mold obtained from the photocurable resin composition for imprinting of the present invention has superior adhesion to the substrate.

The photocurable resin composition for imprinting of the present invention may contain, in addition to the (meth)acrylic monomer (A), other photopolymerizable monomers described below in detail in a range that is not detrimental to characteristics of the present invention. Examples of the other photopolymerizable monomers are styrene-based monomers and vinyl-based monomers.

Examples of the styrene-based monomers include styrene; alkyl styrenes such as methylstyrene, dimethylstyrene, trimethylstyrene, ethylstyrene, diethylstyrene, triethylstyrene, propylstyrene, butylstyrene, hexylstyrene, heptylstyrene and octylstyrene; halogenated styrenes such as fluorostyrene, chlorostyrene, bromostyrene, dibromostyrene and iodostyrene; nitrostyrene, acetylstyrene and methoxystyrene.

Examples of the vinyl-based monomers include vinylpyridine, vinylpyrrolidone, vinylcarbazole, divinylbenzene, vinyl acetate and acrylonitrile; conjugated diene monomers such as butadiene, isoprene and chloroprene; halogenated vinyls such as vinyl chloride and vinyl bromide; and halogenated vinylidenes such as vinylidene chloride.

In the photocurable resin composition for imprinting of the present invention, the amount of the above-described other photopolymerizable monomer excluding the (meth)acrylic monomer (A) is preferably 0 to 30 parts by weight, more preferably 0 to 10 parts by weight, with respect to 100 parts by weight of the (meth)acrylic monomer (A) in the photocurable resin composition for imprinting. By using the photopolymerizable monomer in the above amount in addition to the (meth) acrylic monomer (A), a resin mold that has good precision can be formed. Meanwhile, if the amount is outside the above range, light transmittance tends to be lowered.

The (meth)acrylic monomers and other photopolymerizable monomers mentioned above as examples can be used singly or in combination of two or more kinds.

### 2. Silicon-containing Monomer (B)

In the photocurable resin composition for imprinting of the present invention, the silicon-containing monomer (B) having a reactive group copolymerizable with the component (A) is used. The photocurable resin composition for imprinting of the present invention, by containing the silicon-containing monomer (B), allows the imprinting mold obtained from the composition by imprinting to have improved releasability from a transfer target.

The silicon-containing monomer (B) having a reactive group copolymerizable with the component (A) is not particularly limited as long as being a monomer having silicon and having a reactive group copolymerizable with the (meth)acrylic monomer (A). By having the reactive group, the silicon-containing monomer (B) is incorporated into polymers formed from e.g., the (meth)acrylic monomer (A), not bleeding out onto surfaces of an imprinting mold obtained from the photocurable resin composition for imprinting of the present invention. Examples of the reactive group, in view of reactivity with the (meth) acrylic monomer (A), are a vinyl group, an allyl group and a (meth) acryloyl group. A (meth) acryloyl group is preferred.

Examples of the silicon-containing monomer (B) include 3-methacryloxypropyltrimethoxysilane, 3-methacryloxypropylmethyldimethoxysilane, 3-methacryloxypropylmethyldiethoxysilane, 3-methacryloxypropyltriethoxysilane and 3-acryloxypropyltrimethoxysilane. 3-methacryloxypropyltrimethoxysilane and 3-acryloxypropyltrimethoxysilane are preferred.

It is preferred that the silicon-containing monomer (B) be not a silicone compound, since the silicon-containing monomer (B) being a silicone compound would increase the viscosity of the photocurable resin composition for imprinting due to silicone chains in some cases.

In the present invention, the content of the silicon-containing monomer (B) in the photocurable resin composition for imprinting with respect to 100 parts by weight of the (meth) acrylic monomer (A) in the photocurable resin composition for imprinting is preferably 0.1 to 60 parts by weight, more preferably 0.5 to 45 parts by weight, still more preferably 1.0 to 35 parts by weight. When the content of the silicon-containing monomer (B) in the photocurable resin composition for imprinting falls within the above range, the mold obtained from the composition has superior releasability from a transfer target.

### 3. Photoinitiator (C)

In the photocurable resin composition for imprinting of the present invention, the alkylphenone-based photoinitiator (C1) and the acylphosphine oxide-based photoinitiator (C2) are used in combination as a photoinitiator.

Using the alkylphenone-based photoinitiator (C1) and the acylphosphine oxide-based photoinitiator (C2) in combination as a photoinitiator is believed to make polymerization rate moderately low and to cause polymerization to proceed in such a manner that unpolymerized part of the resin composition is incorporated into between a resin polymerized and shrunk and the master mold, whereby the curing shrinkage of a mold obtainable from the composition of the present invention by photocuring can be decreased; and the resin polymerized later is believed to adequately form a crosslinked structure on the surface and provide the surface with higher hardness than the resin polymerized earlier, so that increased surface hardness is attained.

In the present invention, the amounts of both the photoinitiators in the photocurable resin composition for imprinting with respect to 100 parts by weight of the (meth) acrylic monomer (A) in the photocurable resin composition for imprinting are such that the alkylphenone-based photoinitiator (C1) is used preferably at 0.01 to 20 parts by weight, more preferably 0.1 to 15 parts by weight, further preferably 0.5 to 10 parts by weight, and the acylphosphine oxide-based photoinitiator (C2) is used preferably at 0.01 to 20 parts by weight, more preferably 0.1 to 15 parts by weight, further preferably 0.5 to 10 parts by weight.

Using the alkylphenone-based photoinitiator (C1) and the acylphosphine oxide-based photoinitiator (C2) in the above ranges can control radical generation amount.

A weight ratio (C1: C2) of the alkylphenone-based photoinitiator (C1) to the acylphosphine oxide-based photoinitiator (C2) is in the range of 1:99 to 90:10, preferably 5:95 to 80:20, more preferably 10:90 to 70:30.

By using the alkylphenone-based photoinitiator (C1) and the acylphosphine oxide-based photoinitiator (C2) at the weight ratio described above, a relatively hard polymer can be formed at a polymerization rate that is moderately low, and yellowing of the resulting polymer can be suppressed.

The alkylphenone-based photoinitiator is preferably a nitrogen-free compound. More preferred examples are 2,2-dimethoxy-1,2-diphenylethane-1-one, 1-hydroxy-cyclohexyl-phenyl-ketone, 2-hydroxy-2-methyl-1-phenyl-propane-1-one, 1-[4-(2-hydroxyethoxy)-phenyl]-2-hydroxy-2-methyl-propane-1-o ne and 2-hydroxy-1-{[4-(2-hydroxy-2-methyl-propionyl)-benzyl]phenyl} -2-methyl-propane-1-one; and most preferred is 1-hydroxy-cyclohexyl-phenyl-ketone.

Examples of commercially-available products of the alkylphenone-based photoinitiators include IRGACURE 651, IRGACURE 184, IRGACURE 2959, IRGACURE 127, IRGACURE 907 and IRGACURE 369 (each of these is manufactured by BASF) and IRGACURE 1173 (manufactured by Ciba Japan K.K.).

Preferred examples of the acylphosphine oxide-based photoinitiator are 2,4,6-trimethylbenzoyl-diphenyl-phosphine oxide and bis(2,4,6-trimethylbenzoyl)-phenylphosphine oxide; and bis(2,4,6-trimethylbenzoyl)-phenylphosphine oxide is most preferred.

Examples of commercially-available products of the acylphosphine oxide-based photoinitiators include LUCIRIN TPO and IRGACURE 819 (each of these is manufactured by BASF).

### 4. Others

It is preferred that the photocurable resin composition for imprinting of the present invention be composed of monomers alone and contain no polymers and/or no oligomers. The absence of polymers and/or of oligomers prevents the viscosity from increasing, which makes it possible to apply the composition thinly on a substrate and to provide an imprinting mold superior in flexibility. The imprinting mold superior in flexibility can contact a transfer target resin uniformly and stably, contacting even a transfer target resin with its surfaces curved such as the one lying on a roller.

The photocurable resin composition for imprinting of the present invention may contain components such as a solvent, a chain transfer agent, an antioxidant, a photosensitizer, a filler and a leveling agent, in a range that is not detrimental to properties of the photocurable resin composition for imprinting of the present invention.

The photocurable resin composition for imprinting of the present invention can be produced by mixing the above components through a known method.

### <Photocurable Resin Composition for Imprinting Usage Method>

The photocurable resin composition for imprinting of the present invention is used for photo-imprinting conducted for producing an imprinting mold having a surface on which a fine pattern of e.g., a master mold is formed.

The photo-imprinting includes:
(I-1) a step of applying, on a substrate, the photocurable resin composition for imprinting of the present invention,
(II-1) a step of bringing a master mold having a surface on which a fine pattern is formed into contact with the photocurable resin composition for imprinting applied on the substrate,
(III) a step of applying light to the photocurable resin composition for imprinting provided between the substrate and the master mold to cure the photocurable resin composition for imprinting, and
(IV) a step of releasing the master mold from the photocurable resin composition for imprinting that has been cured.

The steps (I-1) and (II-1) may be:
(I-2) a step of dropwise adding the photocurable resin composition for imprinting of the present invention on a master mold having a surface on which a fine pattern is formed, and
(II-2) a step of covering a surface of the photocurable resin composition for imprinting with a substrate, respectively.

Consequently, an imprinting mold having a surface on which the fine pattern of the surface of the master mold has been transferred is produced.

Examples of the substrate used in the steps (I-1) and (II-2) include resins, glass, silicon, sapphire, gallium nitride, carbon and silicon carbide.

Preferred examples of the resins used for the substrate include polyethylene terephthalate, polycarbonate, polyester, methyl polymethacrylate, polystyrene, polyolefin, polyimide, polysulfone, polyether sulfone and polyethylene naphthalate.

As a form of the resin used for the substrate, the resin in a plate form and the resin in a film form can be mentioned. The form is selected according to imprinting mode.

Exemplary methods of applying on the substrate the photocurable resin composition for imprinting of the present invention in the step (I-1) include spin coating, spray coating, bar coating, dip coating, die coating and slit coating.

The amount of the photocurable resin composition for imprinting of the present invention to be applied on the substrate in the step (I-1) and to be dropwise added to the master mold in the step (I-2) is preferably 1×10⁻⁴ to 1×10⁻¹ g/cm², more preferably 1×10⁻³ to 1×10⁻² g/cm².

The fine pattern formed on the surface of the master mold in the steps (II-1) and (I-2) is generally a concave-convex pattern repeating in a predetermined cycle: specifically, a concave-convex pattern preferably having a cycle of 10 nm to 50 µm, a depth of 10 nm to 100 µm, and a transferred surface of 1.0 to 1.0×10⁶ mm².

Specific examples of the concave-convex form include moth-eye, line, column, monolith, cone, polygonal pyramid and microlens array.

In the step (II-1), the master mold is brought into contact with the photocurable resin composition for imprinting of the present invention generally at a strength of 1.0×10⁻³ to 1.0 MPa and generally kept for 1 to 300 seconds.

Examples of the light used in the step (III) are active energy rays including ultraviolet ray, visible ray, infrared ray and electron ray. Light is generally applied at 100 to 18,000 mJ/cm².

In the step (IV), an operation of separating the master mold from the cured resin is performed.

By the photo-imprinting described above, the photocurable resin composition for imprinting of the present invention is formed into an imprinting mold having a surface on which the fine pattern of the master mold has been transferred.

It is preferred that a surface of the imprinting mold obtained be further subjected to releasing treatment to allow the imprinting mold to have further improved releasability from a transfer target resin.

Examples of the composition used for releasing treatment include compositions containing fluorine and compositions containing silicone. In particular, using a compound containing silicone at its terminal enhances adhesion to an imprinting mold composed of resins containing the silicon-containing monomer (B) . An example of the composition containing a compound having silicone at its terminal used in the releasing treatment is OPTOOL DSX (manufactured by DAIKIN INDUSTRIES, Ltd.).

The releasing treatment can be conducted by immersing the resultant imprinting mold in the above composition usually for 0.1 to 10 minutes . In a more preferred embodiment, the mold having undergone the releasing treatment is heated at 30 to 140°C at a humidity of 20 to 90% for 10 to 300 minutes, so that the above-described composition forms a solid chemical bond on surfaces of the imprinting mold, thus having increased releasability.

### <Imprinting Mold Obtained from Photocurable Resin Composition for Imprinting>

### 1. Properties of Imprinting Mold

The imprinting mold having a surface on which the fine pattern of the master mold has been transferred which is obtained from the photocurable resin composition for imprinting of the present invention by photo-imprinting has properties described below.

The imprinting mold has superior releasability from a transfer target resin, since the resin composition used to produce the imprinting mold contains the silicon-containing monomer (B) .

The fine pattern formed on the surface of the imprinting mold preferably has a shrinkage factor of not more than 10%, more preferably 0 to 3% with respect to the fine pattern of the master mold, as measured by a method described in Examples.

The shrinkage factor as described above is possible because of using the alkylphenone-based photoinitiator (C1) and the acylphosphine oxide-based photoinitiator (C2) in combination as a photoinitiator used in the photocurable resin composition for imprinting of the present invention.

Using the photoinitiators described above in combination makes polymerization rate moderately low and causes polymerization to proceed in such a manner that unpolymerized part of the resin composition is incorporated into between a resin polymerized and shrunk and the master mold, resulting in decrease of curing shrinkage.

The imprinting mold preferably has a surface hardness of 3B to 3H, preferably B to H, as measured by a method described in Examples. The surface hardness described above is believed to be possible because of a more amount of the multifunctional monomer in the photocurable resin composition for imprinting of the present invention thereby allowing its cured product to have increased crosslinking density.

The imprinting mold preferably has a YI value of 0.5 to 20, more preferably 1 to 10, as measured by a method described in Examples. It is preferred that a value obtained by subtracting a YI value of the imprinting mold before irradiated with light at 18,000 mJ/cm² from a YI value of the imprinting mold after irradiated with light at 18,000 mJ/cm² be 0.0 to 3.0, more preferably 0.0 to 2.0. By the above feature, the imprinting mold has high transmittance. Thus, when the imprinting mold of the present invention is used as an imprinting mold, the mold even when exposed to repeated light application hardly undergoes its yellowing and the decrease of its transmittance is suppressed.

The reason why yellowing of the imprinting mold is suppressed is because the photoinitiator used in the photocurable resin composition for imprinting of the present invention is the combination of the alkylphenone-based photoinitiator (C1) and the acylphosphine oxide-based photoinitiator (C2) at the weight ratio and amounts described above. By virtue of the combination of these initiators at the weight ratio and amounts described above, the individual photoinitiators are believed to cooperate with each other to control the generation of radicals leading to the suppression of yellowing.

### 2. Use of Imprinting Mold

The imprinting mold is suited for thermal imprinting or photo-imprinting.

### Examples

Hereinafter, the present invention will be further specifically described with reference to Examples, but the present invention is not limited to these Examples.

### [Examples 1 to 3]

To 75 parts by weight of tripropylene glycol diacrylate (APG-200), 20 parts by weight of nonylphenol EO-modified acrylate (M166), 5 parts by weight of phenol EO-modified acrylate (M144) and 15 parts by weight of 3-methacryloxypropyltrimethoxysilane(KBM503), bis(2,4,6-trimethylbenzoyl)-phenylphosphine oxide (IRGACURE 819) and 1-hydroxy-cyclohexyl-phenyl-ketone (IRGACURE 184) each in an amount shown in Table 1 were incorporated as photoinitiators, to prepare a photocurable resin composition. Composition thereof is shown in Table 1.

### [Examples 4 to 6]

To 75 parts by weight of EO-modified trimethylolpropene triacrylate (M-350), 20 parts by weight of nonylphenol EO-modified acrylate (M166), 5 parts by weight of phenol EO-modified acrylate (M144) and 15 parts by weight of 3-methacryloxypropyltrimethoxysilane (KBM503), bis(2,4,6-trimethylbenzoyl)-phenylphosphine oxide (IRGACURE 819) and 1-hydroxy-cyclohexyl-phenyl-ketone (IRGACURE 184) each in an amount shown in Table 1 were incorporated as photoinitiators, to prepare a photocurable resin composition. Composition thereof is shown in Table 1.

### [Comparative Examples 1 and 2]

As Comparative Examples, instead of IRGACURE 819 of Example 1 described above, 2-methyl-1[4-(methylthio)phenyl]-2-morpholinopropane-1-one (IRGACURE 907) or 2-benzyl-2-dimethylamino-1-(4-morpholinophenyl)-butanone-1 (IRGACURE 369) each in an amount shown in Table 1 was incorporated, to prepare a photocurable resin composition. Composition thereof is shown in Table 1.

### [Comparative Examples 3 and 4]

Example 1 was repeated except that in Example 1 described above, KBM503 was not used and instead of IRGACURE 819, 2-methyl-1[4-(methylthio)phenyl]-2-morpholinopropane-1-one (IRGACURE 907) or 2-benzyl-2-dimethylamino-1-(4-morpholinophenyl)-butanone-1 (IRGACURE 369) in an amount shown in Table 1 was incorporated, to prepare a photocurable resin composition. Composition thereof is shown in Table 1.

Unit of amounts shown in Table 1 is part (s) by weight, and the components (A), namely APG-200, M-350, M166 and M144, total 100 parts by weight.

A sample was produced in such a manner as described below.

To a nickel master mold (outer diameter of the mold: □30 mm, shape pattern: microhole, shape size: 1.7 pm in diameter, cycle: 3.0 µm, height: 1.7 µm) which had undergone releasing treatment using a fluorine-based releasing agent (OPTOOL HD-2100 manufactured by DAIKIN INDUSTRIES, Ltd.), 0.1 ml of each of the resin compositions obtained in Examples 1 to 6 and Comparative Examples 1 to 4 was dropwise added, and the resin composition was covered with a polyethylene terephthalate substrate (thickness: 188 µm). Thereafter, on the substrate, a roller was rolled to uniformly extend the resin liquid (2.5×10⁻³g/cm²). Thereafter, by using a UV irradiation device (UVC-408 manufactured by Technovision, Inc.), UV light at an accumulated light quantity of 1800 mJ/cm² was applied to cure the resin. Thereafter, the polyethylene terephthalate/the cured resin laminate was released from the master mold, giving a transcript product.

The transcript product was immersed in OPTOOL DSX (manufactured by DAIKIN INDUSTRIES, Ltd.) for 1 minute for releasing treatment. Each transcript product obtained from each of the compositions of Examples 1 and 4 was subjected to the releasing treatment, which was then defined as a sample. Each transcript product obtained from each of the compositions of Examples 2, 3, 5 and 6 as well as Comparative Examples 1 to 4 was subjected to the releasing treatment and thereafter to heating at 60°C and at a humidity of 90% for 120 minutes, which was then defined as a sample.

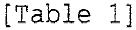

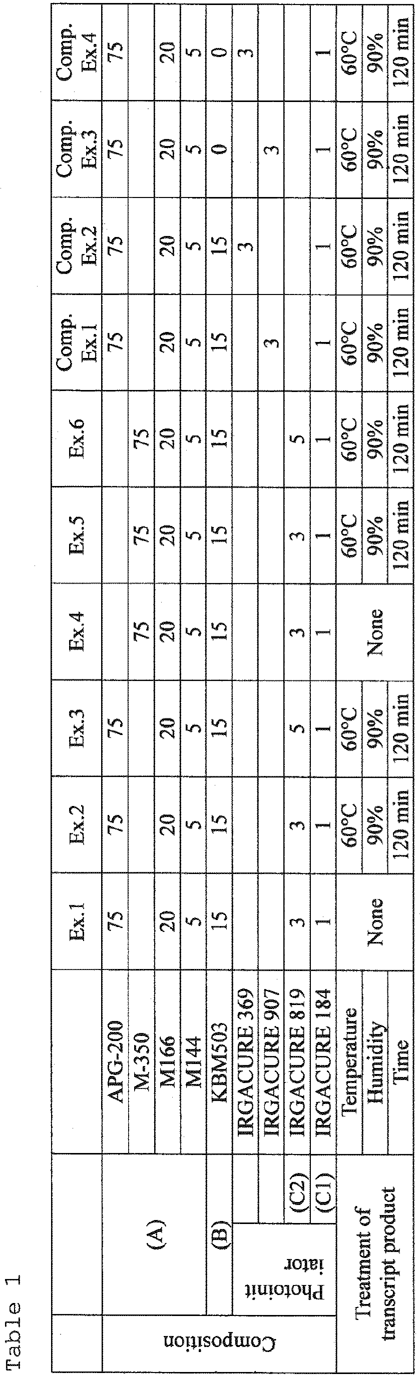

The meanings of abbreviations in the table are as follows. APG-200: (tripropylene glycol diacrylate, Shin-Nakamura Chemical Co., Ltd, product name: NK Ester APG-200)
M-350: (EO-modified trimethylolpropene triacrylate, manufactured by TOAGOSEI CO., LTD., product name (ARONIX M-350))
M166 (nonylphenol EO-modified acrylate, manufactured by MIWON, product name: MIRAMER M-166)
M144 (phenol EO-modified acrylate, manufactured by MIWON, product name: MIRAMER M-144)
KBM503: (3-methacryloxypropyltrimethoxysilane, manufactured by Shin-Etsu Chemical Co., Ltd., product name: KBM-503)
IRGACURE 369: (2-benzyl-2-dimethylamino-1-(4-morpholinophenyl)-butanone-1, manufactured by BASF, product name: IRGACURE 369)
IRGACURE 907: (2-methyl-1[4-(methylthio)phenyl]-2-morpholinopropane-1-one, manufactured by BASF, product name: IRGACURE 907)
IRGACURE 819: (bis(2,4,6-trimethylbenzoyl)-phenylphosphine oxide, manufactured by BASF, product name: IRGACURE 819)
IRGACURE 184: (1-hydroxy-cyclohexyl-phenyl-ketone, manufactured by BASF, product name: IRGACURE 184)

Measurements for obtaining measured values in Examples are conducted in the following manners.

### <Releasability from Transfer Target>

Onto the sample described above, 0.1 ml of a UV curable resin for nano-imprinting (manufactured by Toyo Gosei Co., Ltd, product name: PAK-02) was dropwise added, which was then covered with a polyethylene terephthalate substrate (thickness: 188 µm). Thereafter, the resin liquid was uniformly extended with a roller (2.5×10⁻³g/cm²). Thereafter, by using a UV irradiation device (UVC-408 manufactured by Technovision, Inc.), UV light at an accumulated light quantity of 1800 mJ/cm² was applied to cure the resin. Then, a test of releasing the polyethylene terephthalate/cured resin laminate from the sample was repeated, and the number of tests that were able to be carried out in which the laminate was released from the sample with no fracture was counted.

### [Table 2]

**Table 2**

| | Example 1 | Example 2 | Example 3 | Example 4 |
|---|---|---|---|---|
| Number of times of continuous transferring | >10 | >20 | >20 | >10 |

| | Example 5 | Example 6 | Comparative Example 3 | Comparative Example 4 |
|---|---|---|---|---|
| Number of times of continuous transferring | >20 | >20 | 0 | 0 |

### <Measurement of Dimension>

Considering that curing shrinkage is observed conspicuously in the direction of the height of a shape, the height (distance between the top of the convex part and a base surface) of a shape of the master mold and of the sample obtained was measured.

For the measurement, as a measuring instrument, L-trace, manufactured by SII Nano Technology, Inc., was used. Used were a master mold (outer diameter of the mold: D30 mm, shape pattern: microhole, shape size: 1.7 µm in diameter, cycle: 3.0 µm, height: 1.7 µm), as well as each of the samples obtained by transferring the master mold to the photocurable resin compositions of Examples 1, 3, 4 and 6 and Comparative Examples 1 and 2. Heights at five places for the master mold or for each of the samples were averaged. Results of these are shown in Table 3. In Table 3, shrinkage factor with respect to the master mold = (height of the master mold - height of the sample)/height of the master mold.

### [Table 3]

**Table 3**

| | Master mold | Example 1 | Example 3 | Example 4 |
|---|---|---|---|---|
| Height (unit: µm) | 1.70 | 1.67 | 1.65 | 1.68 |
| Shrinkage factor with respect to master mold (%) | - | 1.8 | 2.9 | 1.2 |

| | Example 6 | Comparative Example 1 | Comparative Example 2 | |
|---|---|---|---|---|
| Height (unit: µm) | 1.65 | 1.63 | 1.63 | |
| Shrinkage factor with respect to master mold (%) | 2.9 | 4.1 | 4.1 | |

### <Surface Hardness>

In accordance with pencil hardness stipulated in JIS K5600-5-4, surface hardnesses of the cured resins were measured. Results are shown in Table 4.

### <Yellowing Degree>

The above samples, and samples given after applying UV to the above samples at an accumulated light quantity of 18,000 mJ/cm², were subjected to YI value measurement using a measuring instrument (a general-purpose color difference meter, Color Ace TC-8600A, manufactured by Tokyo Denshoku, Co., Ltd.). YI values of the above samples before irradiated and of the samples after irradiated are shown in Table 4. In Table 4, ΔYI = YI value of sample after irradiated with light at 18,000 mJ/cm² - YI value of sample before irradiated with light at 18,000 mJ/cm².

### <Transmittance>

Transmittances in thickness with respect to light at 365 nm of the above samples and the samples given after applying UV to the above samples at an accumulated light quantity of 18,000 mJ/cm² were measured by using a measuring instrument (V-670, ultraviolet-visible near infrared spectrophotometer, manufactured by JASCO Corporation). The transmittances of the above samples and of the samples given after the irradiation are shown in Table 4.

### [Table 4]

**Table 4**

| | Example 1 | | Example 3 | | Example 4 | |
|---|---|---|---|---|---|---|
| UV-irradiated | Resin composition | Sample | Resin composition | Sample | Resin composition | Sample |
| Accumulated light quantity (mJ/cm²) | 1,800 | 18,000 | 1,800 | 18,000 | 1,800 | 18,000 |
| Surface hardness | F | F | F | F | F | F |
| YI value | 4.1 | 4.5 | 5.3 | 5.8 | 3.9 | 4.4 |
| ΔYI | 0.4 | | 0.5 | | 0.5 | |
| Thickness (µm) | 20 | | 30 | | 20 | |
| Transmittance (365 nm) (%) | 69.3 | 69.1 | 67.1 | 66.2 | 69.5 | 69.3 |

| | Example 6 | | Comparative Example 1 | | Comparative Example 2 | |
|---|---|---|---|---|---|---|
| UV-irradiated | Resin composition | Sample | Resin composition | Sample | Resin composition | Sample |
| Accumulated light quantity (mJ/cm²) | 1,800 | 18,000 | 1,800 | 18,000 | 1,800 | 18,000 |
| Surface hardness | F | F | F | F | F | F |
| YI value | 5.4 | 5.9 | 3.9 | 25.0 | 13.8 | 20.0 |
| ΔYI | 0.5 | | 21.1 | | 6.2 | |
| Thickness (µm) | 30 | | 20 | | 30 | |
| Transmittance (365 nm) (%) | 67.0 | 66.2 | 58.5 | 25.3 | 47.0 | 29.4 |

It is found from Table 2 that cured molds given from the photocurable resin compositions of the present invention, having superior releasability and preventing transfer targets from adhering thereto, can be used for continuous transferring ten or more times.

It is verified from Table 3 that when the master mold was transferred to the photocurable resin composition of the present invention, the shape of the master mold was transferred thereto with good precision, leading to the provision of molds significantly superior in precision of shape dimension.

It is verified from Table 4 that the cured resins of the present invention are free from yellowing and can retain transmittance significant as a mold. It is also found that the structures have a surface hardness evaluated as F. The high surface hardness is provided presumably because of using more amount of a multifunctional monomer as a monomer thereby allowing the structure to have high crosslinking density.

### Industrial Applicability

The photocurable resin composition for imprinting of the present invention is applicable to the production of imprinting molds and has utility significantly high on an industrial basis.

## Claims

1. A photocurable resin composition for imprinting comprising a (meth)acrylic monomer (A), a silicon-containing monomer (B) having a reactive group copolymerizable with the component (A), and a photoinitiator (C), wherein the photoinitiator (C) comprises a combination of an alkylphenone-based photoinitiator (C1) and an acylphosphine oxide-based photoinitiator (C2), and wherein the (meth)acrylic monomer (A) is at least one kind selected from the group consisting of nonylphenol EO-modified acrylate, phenol EO-modified acrylate and tripropylene glycol diacrylate.

2. The photocurable resin composition for imprinting according to claim 1, which comprises, with respect to 100 parts by weight of the (meth)acrylic monomer (A), 0.1 to 60 parts by weight of the silicon-containing monomer (B), 0.01 to 20 parts by weight of the alkylphenone-based photoinitiator (C1) and 0.01 to 20 parts by weight of the acylphosphine oxide-based photoinitiator (C2).

3. The photocurable resin composition for imprinting according to claim 1 or 2, wherein the alkylphenone-based photoinitiator (C1) is at least one kind selected from the group consisting of 2,2-dimethoxy-1,2-diphenylethane-1-one, 1-hydroxy-cyclohexyl-phenyl-ketone, 2-hydroxy-2-methyl-1-phenyl-propane-1-one, 1-[4-(2-hydroxyethoxy)-phenyl]-2-hydroxy-2-methyl-propane-1-one and 2-hydroxy-1-{[4-(2-hydroxy-2-methyl-propionyl)-benzyl]phenyl}-2-methyl-propane-1-one.

4. The photocurable resin composition for imprinting according to any one of claims 1 to 3, wherein the acylphosphine oxide-based photoinitiator (C2) is at least one kind selected from the group consisting of 2,4,6-trimethylbenzoyl-diphenyl-phosphine oxide and bis(2,4,6-trimethylbenzoyl)-phenylphosphine oxide.

5. The photocurable resin composition for imprinting according to any one of claims 1 to 4, wherein a blending weight ratio (C1:C2) of the alkylphenone-based photoinitiator (C1) to the acylphosphine oxide-based photoinitiator (C2) is in the range of 1:99 to 90:10.

6. The photocurable resin composition for imprinting according to claim 5, wherein the alkylphenone-based photoinitiator (C1) is 1-hydroxy-cyclohexyl-phenyl-ketone and the acylphosphine oxide-based photoinitiator (C2) is bis(2,4,6-trimethylbenzoyl)-phenylphosphine oxide, and wherein a blending weight ratio (C1:C2) of the alkylphenone-based photoinitiator (C1) to the acylphosphine oxide-based photoinitiator (C2) is in the range of 10:90 to 70:30.

7. The photocurable resin composition for imprinting according to any one of claims 1 to 6, wherein the photocurable resin composition for imprinting contains no oligomers and/or no polymers.

8. A method for producing an imprinting mold having a surface on which a fine pattern is formed, comprising:
(I) a step of applying, on a substrate, the photocurable resin composition for imprinting according to any one of claims 1 to 7,
(II) a step of bringing a master mold having a surface on which a fine pattern is formed into contact with the photocurable resin composition for imprinting applied on the substrate,
(III) a step of applying light to the photocurable resin composition for imprinting provided between the substrate and the master mold to cure the photocurable resin composition for imprinting, and
(IV) a step of releasing the master mold from the photocurable resin composition for imprinting that has been cured.

9. A method for producing an imprinting mold having a surface on which a fine pattern is formed, comprising:
(I) a step of dropwise adding the photocurable resin composition for imprinting according to any one of claims 1 to 7 on a master mold having a surface on which a fine pattern is formed,
(II) a step of covering a surface of the photocurable resin composition for imprinting with a substrate,
(III) a step of applying light to the photocurable resin composition for imprinting provided between the substrate and the master mold to cure the photocurable resin composition for imprinting, and
(IV) a step of releasing the master mold from the photocurable resin composition for imprinting that has been cured.

10. An imprinting mold obtained by the production process according to claim 8 or 9.

11. The imprinting mold according to claim 10, which has been subjected to releasing treatment.

12. The imprinting mold according to claim 10 or 11, which has a fine pattern with a shrinkage factor of not more than 10% with respect to the fine pattern of the master mold.

13. The imprinting mold according to any one of claims 10 to 12, wherein a value obtained by subtracting a YI value of the mold before irradiated with light at 18,000 mJ/cm² from a YI value of the mold after irradiated with light at 18,000 mJ/cm² is 0.0 to 3.0.

14. The imprinting mold according to any one of claims 10 to 13, which has a surface hardness of 3B to 3H in terms of pencil hardness in accordance with JIS K5600 5-4.

## Patentansprüche

1. Lichthärtbare Harzzusammensetzung für das Prägen, umfassend ein (Meth)acrylMonomer (A), ein siliciumhaltiges Monomer (B) mit einer mit der Komponente (A) copolymerisierbaren reaktiven Gruppe, und einen Photoinitiator (C), wobei der Photoinitiator (C) eine Kombination aus einem Alkylphenon-basierten Photoinitiator (C1) und einem Acylphosphinoxid-basierten Photoinitiator (C2) umfasst, und wobei das (Meth)acryl-Monomer (A) mindestens eine Art ist, die ausgewählt ist aus der Gruppe bestehend aus mit ethoxyliertem Nonylphenol modifiziertem Acrylat, mit ethoxyliertem Phenol modifiziertem Acrylat und Tripropylenglykol-Diacrylat.

2. Lichthärtbare Harzzusammensetzung für das Prägen nach Anspruch 1, umfassend, in Bezug auf 100 Gewichtsanteile des (Meth)acryl-Monomers (A), 0,1 bis 60 Gewichtsanteile des siliciumhaltigen Monomers (B), 0,01 bis 20 Gewichtsanteile des Alkylphenon-basierten Photoinitiators (C1) und 0,01 bis 20 Gewichtsanteile des Acylphosphinoxid-basierten Photoinitiators (C2).

3. Lichthärtbare Harzzusammensetzung für das Prägen nach Anspruch 1 oder 2, wobei der Alkylphenon-basierte Photoinitiator (C1) mindestens eine Art ist, die ausgewählt ist aus der Gruppe bestehend aus 2,2-Dimethoxy-1,2-diphenylethan-1-on, 1-Hydroxy-cyclohexyl-phenyl-keton, 2-Hydroxy-2-methyl-1-phenyl-propan-1-on, 1-[4-(2-Hydroxyethoxy)-phenyl]-2-hydroxy-2-methyl-propan-1-on und 2-Hydroxy-1-{[4-(2-hydroxy-2-methyl-propionyl)-benzyl]phenyl}-2-methyl-propan-1-on.

4. Lichthärtbare Harzzusammensetzung für das Prägen nach einem der Ansprüche 1 bis 3, wobei der Acylphosphinoxid-basierte Photoinitiator (C2) mindestens eine Art ist, die ausgewählt ist aus der Gruppe bestehend aus 2,4,6-Trimethylbenzoyl-diphenylphosphinoxid und Bis(2,4,6-trimethylbenzoyl)-phenylphosphinoxid.

5. Lichthärtbare Harzzusammensetzung für das Prägen nach einem der Ansprüche 1 bis 4, wobei ein Mischgewichtsverhältnis (C1:C2) zwischen dem Alkylphenon-basierten Photoinitiator (C1) und dem Acylphosphinoxid-basierten Photoinitiator (C2) im Bereich von 1:99 bis 90:10 liegt.

6. Lichthärtbare Harzzusammensetzung für das Prägen nach Anspruch 5, wobei der Alkylphenon-basierte Photoinitiator (C1) 1-Hydroxy-cyclohexyl-phenyl-keton ist und der Acylphosphinoxid-basierte Photoinitiator (C2) Bis(2,4,6-trimethylbenzoyl)-phenylphosphinoxid ist, und wobei ein Mischgewichtsverhältnis (C1:C2) zwischen dem Alkylphenon-basierten Photoinitiator (C1) und dem Acylphosphinoxid-basierten Photoinitiator (C2) im Bereich von 10:90 bis 70:30 liegt.

7. Lichthärtbare Harzzusammensetzung für das Prägen nach einem der Ansprüche 1 bis 6, wobei die lichthärtbare Harzzusammensetzung für das Prägen keine Oligomere und/oder keine Polymere enthält.

8. Verfahren zum Herstellen einer Prägeform mit einer Oberfläche, auf der eine Feinstruktur gebildet ist, umfassend:
(i) einen Schritt des Auftragens, auf einem Substrat, der lichthärtbaren Harzzusammensetzung für das Prägen nach einem der Ansprüche 1 bis 7,
(ii) einen Schritt des Bringens einer Mutterform mit einer Oberfläche, auf der eine Feinstruktur gebildet ist, in Kontakt mit der lichthärtbaren Harzzusammensetzung für das Prägen, die auf dem Substrat aufgetragen ist,
(iii) einen Schritt des Aufbringens von Licht auf die lichthärtbare Harzzusammensetzung für das Prägen, die zwischen dem Substrat und der Mutterform bereitgestellt ist, um die lichthärtbare Harzzusammensetzung für das Prägen auszuhärten, und
(iv) einen Schritt des Freigebens der Mutterform von der lichthärtbaren Harzzusammensetzung für das Prägen, die ausgehärtet wurde.

9. Verfahren zum Herstellen einer Prägeform mit einer Oberfläche, auf der eine Feinstruktur gebildet ist, umfassend:
(i) einen Schritt des tropfenweisen Zugebens der lichthärtbaren Harzzusammensetzung für das Prägen nach einem der Ansprüche 1 bis 7 auf einer Mutterform mit einer Oberfläche, auf der eine Feinstruktur gebildet ist,
(ii) einen Schritt des Bedeckens einer Fläche der lichthärtbaren Harzzusammensetzung für das Prägen mit einem Substrat,
(iii) einen Schritt des Aufbringens von Licht auf die lichthärtbare Harzzusammensetzung für das Prägen, die zwischen dem Substrat und der Mutterform bereitgestellt ist, um die lichthärtbare Harzzusammensetzung für das Prägen auszuhärten, und
(iv) einen Schritt des Freigebens der Mutterform von der lichthärtbaren Harzzusammensetzung für das Prägen, die ausgehärtet wurde.

10. Prägeform, die durch den Herstellungsprozess nach Anspruch 8 oder 9 erhalten wird.

11. Prägeform nach Anspruch 10, die einer Freigabebehandlung unterzogen wurde.

12. Prägeform nach Anspruch 10 oder 11, die eine Feinstruktur mit einem Schwindungswert von nicht mehr als 10 % in Bezug auf die Feinstruktur der Mutterform hat.

13. Prägeform nach einem der Ansprüche 10 bis 12, wobei ein Wert, der erhalten wird, indem ein YI-Wert der Form vor einem Bestrahlen mit Licht von 18.000 mJ/cm² von einem YI-Wert der Form nach dem Bestrahlen mit Licht von 18.000 mJ/cm² subtrahiert wird, 0,0 bis 3,0 beträgt.

14. Prägeform nach einem der Ansprüche 10 bis 13, die eine Oberflächenhärte von 3B bis 3H in Begriffen der Bleistifthärte in Übereinstimmung mit JIS K5600 5-4 hat.

## Revendications

1. Composition de résine photodurcissable pour impression comprenant un monomère (méth)acrylique (A), un monomère contenant du silicium (B) ayant un groupe réactif copolymérisable avec le composant (A), et un photoinitiateur (C), dans laquelle le photoinitiateur (C) comprend une combinaison d'un photoinitiateur à base d'alkylphénone (C1) et d'un photoinitiateur à base d'oxyde d'acylphosphine (C2), et dans laquelle le monomère (méth)acrylique (A) est au moins un type choisi dans le groupe constitué d'acrylate de nonylphénol modifié par de l'oxyde d'éthylène, d'acrylate de phénol modifié par de l'oxyde d'éthylène et de diacrylate de tripropylène glycol.

2. Composition de résine photodurcissable pour impression selon la revendication 1, qui comprend, par rapport à 100 parties en poids du monomère (méth)acrylique (A), de 0,1 à 60 parties en poids du monomère contenant du silicium (B), de 0,01 à 20 parties en poids du photoinitiateur à base d'alkylphénone (C1) et de 0,01 à 20 parties en poids du photoinitiateur à base d'oxyde d'acylphosphine (C2).

3. Composition de résine photodurcissable pour impression selon la revendication 1 ou 2, dans laquelle le photoinitiateur à base d'alkylphénone (C1) est au moins un type choisi dans le groupe constitué de la 2,2-diméthoxy-1,2-diphényléthane-1-one, de la 1-hydroxy-cyclohexyl-phényl-cétone, de la 2-hydroxy-2-méthyl-1-phényl-propane-1-one, de la 1-[4-(2-hydroxyéthoxy)-phényl]-2-hydroxy-2-méthyl-propane-1-one et de la 2-hydroxy-1-{[4-(2-hydroxy-2-méthyl-propionyl)-benzyl]phényl}-2-méthyl-propane-1-one.

4. Composition de résine photodurcissable pour impression selon l'une quelconque des revendications 1 à 3, dans laquelle le photoinitiateur à base d'oxyde d'acylphosphine (C2) est au moins un type choisi dans le groupe constitué de l'oxyde de 2,4,6-triméthylbenzoyl-diphényl-phosphine et de l'oxyde de bis(2,4,6-triméthylbenzoyl)-phénylphosphine.

5. Composition de résine photodurcissable pour impression selon l'une quelconque des revendications 1 à 4, dans laquelle un rapport pondéral de mélange (C1:C2) du photoinitiateur à base d'alkylphénone (C1) au photoinitiateur à base d'oxyde d'acylphosphine (C2) est dans la plage de 1:99 à 90:10.

6. Composition de résine photodurcissable pour impression selon la revendication 5, dans laquelle le photoinitiateur à base d'alkylphénone (C1) est de la 1-hydroxy-cyclohexyl-phényl-cétone et le photoinitiateur à base d'oxyde d'acylphosphine (C2) est de l'oxyde de bis(2,4,6-triméthylbenzoyl)-phénylphosphine, et dans laquelle un rapport pondéral de mélange (C1:C2) du photoinitiateur à base d'alkylphénone (C1) au photoinitiateur à base d'oxyde d'acylphosphine (C2) est dans la plage de 10:90 à 70:30.

7. Composition de résine photodurcissable pour impression selon l'une quelconque des revendications 1 à 6, dans laquelle la composition de résine photodurcissable pour impression ne contient pas d'oligomères et/ou pas de polymères.

8. Procédé de production d'un moule pour impression ayant une surface sur laquelle un motif fin est formé, comprenant :
(I) une étape d'application, sur un substrat, de la composition de résine photodurcissable pour impression selon l'une quelconque des revendications 1 à 7,
(II) une étape de mise en contact d'un moule maître ayant une surface sur laquelle un motif fin est formé avec la composition de résine photodurcissable pour impression appliquée sur le substrat,
(III) une étape d'application de lumière sur la composition de résine photodurcissable pour impression fournie entre le substrat et le moule maître pour durcir la composition de résine photodurcissable pour impression, et
(IV) une étape de libération du moule maître de la composition de résine photodurcissable pour impression qui a été durcie.

9. Procédé de production d'un moule pour impression ayant une surface sur laquelle un motif fin est formé, comprenant :
(I) une étape d'ajout goutte à goutte de la composition de résine photodurcissable pour impression selon l'une quelconque des revendications 1 à 7 sur un moule maître ayant une surface sur laquelle un motif fin est formé,
(II) une étape de couverture d'une surface de la composition de résine photodurcissable pour impression avec un substrat,
(III) une étape d'application de lumière sur la composition de résine photodurcissable pour impression fournie entre le substrat et le moule maître pour durcir la composition de résine photodurcissable pour impression, et
(IV) une étape de libération du moule maître de la composition de résine photodurcissable pour impression qui a été durcie.

10. Moule pour impression obtenu par le procédé de production selon la revendication 8 ou 9.

11. Moule pour impression selon la revendication 10, qui a été soumis à un traitement de libération.

12. Moule pour impression selon la revendication 10 ou 11, qui a un motif fin avec un facteur de retrait non supérieur à 10 % par rapport au motif fin du moule maître.

13. Moule pour impression selon l'une quelconque des revendications 10 à 12, dans laquelle une valeur obtenue en soustrayant une valeur YI du moule avant d'être irradié avec une lumière à 18000 mJ/cm² d'une valeur YI du moule après avoir été irradié avec une lumière à 18 000 mJ/cm² est de 0,0 à 3,0.

14. Moule pour impression selon l'une quelconque des revendications 10 à 13, qui a une dureté de surface de 3B à 3H en termes de dureté au crayon selon la norme JIS K5600 5-4.
